**Europäisches Patentamt**

**European Patent Office**

**Office européen des brevets**

(19)

(11) Publication number: **0 045 900**
**A1**

(12) # EUROPEAN PATENT APPLICATION

(21) Application number: **81105971.6**

(22) Date of filing: **29.07.81**

(51) Int. Cl.³: **G 01 R 33/02**

(30) Priority: **11.08.80 ES 495068**
**05.09.80 ES 495068**

(43) Date of publication of application:
**17.02.82 Bulletin 82 7**

(84) Designated Contracting States:
**AT BE CH DE FR GB IT LI LU NL SE**

(71) Applicant: **Titus Suru**
**Avda. Mesa y Lopez, 27**
**Las Palmas de Gran Canaria(ES)**

(72) Inventor: **Titus Suru**
**Avda. Mesa y Lopez, 27**
**Las Palmas de Gran Canaria(ES)**

(74) Representative: **Selting, Günther, Dipl.-Ing. et al,**
**Deichmannhaus am Hauptbahnhof**
**D-5000 Köln 1(DE)**

(54) Methods for the continuous conversion of magnetic values into electrical values.

(57) The magnetization of the core of an inductance diminishes its reactance. The magnetization of the core, common to two or more inductive circuits, modifies the characteristics of a local oscillation, the mutual induction and the transference of energy.

The phenomenon is governed by the composition, the form and the dimensions of the core, by the value and the construction characteristics of the inductive and oscillatory circuits and by the reciprocal position of the components with respect to the core.

This method for the continuous conversion of magnetic values into electrical values is based on the determined premagnetization of various core-types of one or various inductive and oscillatory circuits, to obtain significant electrical changes in these circuits, by little alterations of the initial premagnetization.

**VON KREISLER   SCHÖNWALD   EISHOLD   FUES**  0045900

**VON KREISLER   KELLER   SELTING   WERNER**

Titus Suru
Avda. Mesa y López, 27

Las Palmas de Gran Canaria
(Spanien)

PATENTANWÄLTE

Dr.-Ing. von Kreisler † 1973

Dr.-Ing. K. Schönwald, Köln
Dr.-Ing. K. W. Eishold, Bad Soden
Dr. J. F. Fues, Köln
Dipl.-Chem. Alek von Kreisler, Köln
Dipl.-Chem. Carola Keller, Köln
Dipl.-Ing. G. Selting, Köln
Dr. H.-K. Werner, Köln

DEICHMANNHAUS AM HAUPTBAHNHOF
**D-5000 KÖLN 1**

TITLE MODIFIED July 27, 1981
see front page      Sg-vR/fe

## Method of High Sensibility, Stability and Efficiency for the Continuous Conversion of Magnetic Values into Electrical Values

The spectacular development of electronics in the last few decades  has not been paralleled by progress in the field of magnetic transducers for constant values or slowly varying values.

Complicated and costly methods, such as nuclear resonance, specially constructed cathode-ray tubes, rubidium-vapor magnetometers, etc., have applications limited to special cases, and most of the devices, instruments and appliances  for such applications are equipped with Hall-effect elements, which are more efficient than the magneto-resistance.

All these sophisticated or simple transducers have an efficiency between the lowest compulsorily acceptable,

Telefon: (0221) 13 10 41 · Telex: 888 2307 dopa d · Telegramm: Dompatent Köln

and sensitivities which are comparable to that of a compass.

Moreover, the small tensions which they supply, require a big amplification in continuous current, an area in which not even modern electronics has solved the problem. The small variation of temperature induces appreciable drift, and the tendency to instability complicate the amplification of such tensions.

On a world scale, the shortage and price of the devices for magnetic measurement constitutes a handicap in many sectors of scientific investigation and activities including also satellites which are to carry out magnetic space exploration.

Nevertheless, a method exists, based on a phenomenon probably ignored until now, which offers a different perspective. The description follows:

If the core of a suitably coupled circuit, almost synchronized with an external oscillator, is magnetized - without saturating - small alterations of the premagnetization or of the Foucault currents, provoke large variations of the tension in said circuit.

If the core, common to a local oscillator, or to a primary fed by an external oscillator and - at a given distance - to a circuit almost synchronized with the frequency, is premagnetized - without saturating - small alterations of the premagnetization provoke large variations in the value of the induced tension.

The alterations of the premagnetization can be caused by changes in the environmental magnetic field in the case of the open cores, or by small changes in the current which circulates through a winding situated on the same core, in all the cores.

The phenomenon can be more or less observed using any type of core and at all frequencies to an upper limit, governed by the losses of the core.

The rate, form and linearity of the electrical variation are governed by the relative positioning of the components, by the intensity of the premagnetization and by the almost synchronization of one or more of the circuits with the utilized frequency, and also of other known factors.

Enumerating the conditions and the factors which determine the phenomenon, the fundamental characteristic in all its practical applications is evident: the premagnetization - without saturating - of the core of a coil or inductive circuit, or of the core common to various inductive and osciallatory circuits.

The possible practical variables allow an indefinite number of potential applications, such as: various magnetic transducers, orientation in the terrestrial magnetic field, continuous current amplifier, detector of metallic accumulations, proximity detector, vibration detector and transducer, amplitude and frequency modulator, electrical field detector, seismograph, etc.

Bearing in mind from the beginning that the progress in electronics is more than unsatisfactory concerning continuous magnetic transducers and the amplification of small continuous tensions, we shall analyse the phenomenon in this type of application, and implicitly in others, making reference to the figures of the attached drawing; setting out at the same time, and after the final observations, the bases of the method of high sensitivity, stability and efficiency to convert small magnetic values constant or variable, into large electrical values, constant or variable.

If in figures 1 and 3 we exclude S1-S2-P2, and P1 constitutes a circuit, suitably coupled and almost synchronized with an external oscillator, significant amplitude variations appear in the alternating tension existing at the extremes of P1, when a modification of the environmental magnetic field is produced, or when the Foucault currents are modified by the presence or movement of a material diamagnetic or paramagnetic electrical conductor, in the vicinity of the core. The inductance set up on a core with an air-gap of suitable dimensions (fig. 4) allows measurements on magnetic fields in reduced spaces, to detect the presence and nature of metallic bodies, electrical fields, etc.

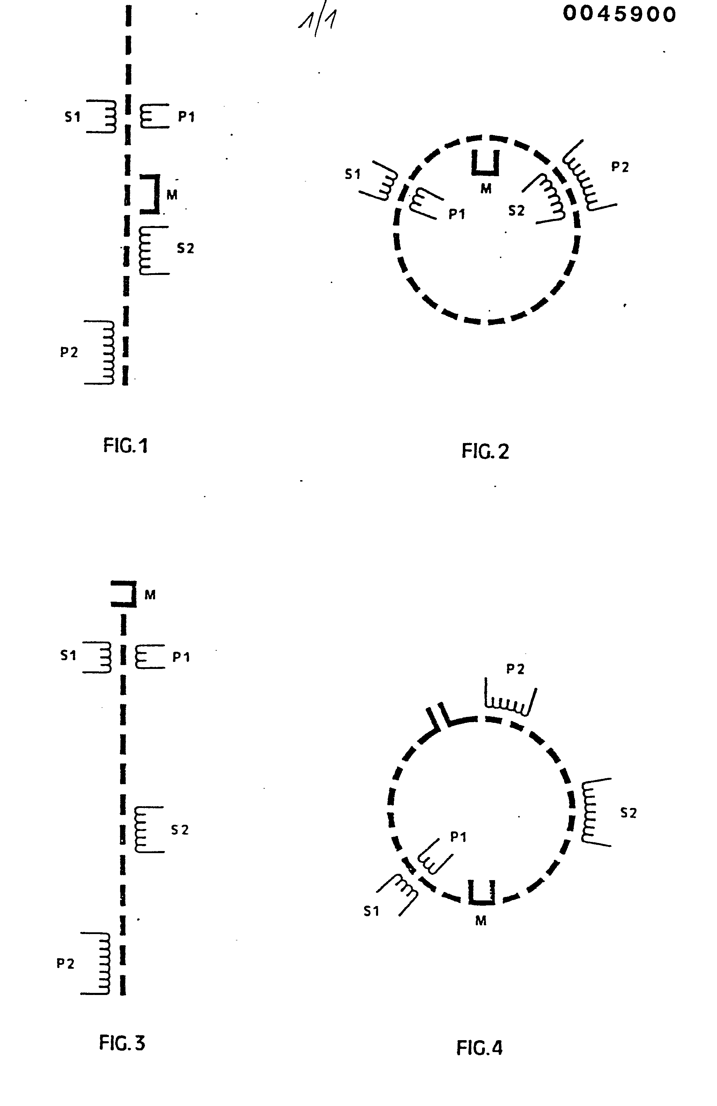

If in figures 1, 2, 3, 4, we exclude only S1, and P1 is suitably coupled and almost synchronized with an external oscillator, and P2 constitutes the load of an amplifier stage of a small continuous tension, the minimum variations of the current which circulates through P2, provoke large variations in the tension induced in S2. To avoid alterations through changes in the environmental magnetic field, closed cores, (fig. 2) or cores with a small air-gap (fig. 4) may be used. If, in the same case, P1 is fed by a frequency carrier and P2 by a modulator, the frequency P1, modulated in amplitude by the frequency P2, will appear in S2.

If in figures 1,2,3,4, P1-S1 constitute a local oscillator, the current variations in P2 provoke significant
variations of amplitude and frequency, detectable and
measureable in S2.

If in the above case S2 is almost synchronized with the
frequency of the local oscillator, larger parallel amplitude variations may appear in S1, dependent upon the
intensity of the premagnetization (M) and of the constructive characteristics of the circuit.

Different type of cores and assembling are used according to the purpose. The difference between the two open
cores shown in figs. 1 and 3 is that the transducer set
up in accordance with fig. 1, allows a symmetry of sensitivity to be obtained in the two extremes.

It is important to note that in all cases:

- A continuous output tension can be obtained, rectifying and filtering the tension to be measured.

- As the windings S1 and S2 can have a much higher
  number of turns than P1, the output tension of the
  transducer can have much higher values than the
  tension used for the power supply.

- As the winding P2 can have a much higher number of
  turns as a load of an amplifier stage of a continuous
  tension, the resulting amplification surpasses that
  of a classical stage, with less temperature drift
  and good stability, owing to the "electrical insulation" created between successive stages.

To be able to judge the prospects of possible practical applications, I would like to give comparative data of transducers for magnetometers, utilizing two types of Hall elements of a recently developed different technology, and a new transducer set up according to fig. 3. For maximum sensitivity each Hall element has been fixed between two ferrite bars of 6,3 mm type 3D3, manufactured by Hispano-Ferritas (Spain), with a total length of 26,5 cm; the new transducer has been made with the same type of bar, 24 cm in length.

The established power supply tension is 1,5 V.

The current consumption in each case is:

- 3 mA for the Hall elements GaAs of JVC, type VHG-210
- 6 mA for the Hall element InSb of Asahi Chemical, type H300A.
- 0,24 mA for the new transducer.

The variation of the continuous output tension through a 360° horizontal rotation in the terrestrial magnetic field in Las Palmas (about 30.000 gamma) measured on a resistance of 10 Mg is:

- 1,7 mV in the case of the Hall element type VHG-210
- 13 mV in the case of the Hall element type H300A.
- 13,2 V (13.200 mV) in the case of the new transducer.

In conclusion the new transducer has a sensitivity of at least a thousand times greater, supplying tensions without problems of amplification, and the efficiency is in excess of 25.000 times the efficiency of the modern Hall elements.

As all the experiments have been carried out only with materials in existence of the open market, and with reduced means, the possible achievement of an extensive range of devices, instruments and appliances can be expected, when more suitable means and materials are available.

After the spectacular results already obtained under these conditions, it does not seem rash to state that the method constitures an important step forward in fundamental electronics, and a means of facilitating significant progress in other scientific sectors.

CLAIMS

1. Method for the continuous conversion of magnetic
   values into electrical values, characterized in that
   it is based on the premagnetization of the core of
   a coil or circuit almost synchronized and suitably
   coupled with an external oscillator, or on the premagnetization of the core common to a local oscillator and at least to a coil or inductive circuit almost synchronized situated in a determined position,
   to obtain, in one or more inductance, large electrical variations caused by small alterations of the
   premagnetization or of the Foucault currents.

2. Method for the continuous conversion of magnetic
   values into electric values according to claim 1,
   characterized in that it is based on the premagnetization of an open core, or a closed core with
   an air-gap of suitable dimensions, on which one of
   the assemblies specified in the first claim is set
   up, to obtain in this way a transducer of high sensitivity, stability and efficiency, which allows
   measurements to be carried out on the environmental
   magnetism or only near the air-gap, to detect and
   evaluate magnetic, diamagnetic or paramagnetic
   materials and also electrical fields, to convert a
   magnetic, mechanical or electrical movement into the
   modulation of a carrier frequency, or to detect and
   value tremors, by the actual movement of the transducer itself in the terrestrial magnetic field.

3. Method for the continuous conversion of magnetic values into electrical values according to claim 1 or 2, characterized in that it is based on the premagnetization of a closed core, or of a core with small air-gap, on which one of the assemblies specified in the first claim is set up, including the coil which constitutes the load of an amplifier stage of continuous current, to obtain in this way a significant amplification of the current variations in the said coil, and to use the method in the setting up an amplifier stage of continuous current of high stability and efficiency.

4. Method for the continuous conversion of magnetic values into electrical values according to one of the preceding claims, characterized in that it is based on the premagnetization of a core on which one of the assemblies specified in the first claim is set up, including a coil connected to an external modulator, to obtain in this way in the assembly, an amplitude modulation of an external frequency or an amplitude and frequency modulation of the local oscillation.

FIG.1

FIG.2

FIG.3

FIG.4

0045900

**European Patent Office**

**EUROPEAN SEARCH REPORT**

Application number

EP 81 10 5971

| DOCUMENTS CONSIDERED TO BE RELEVANT | | |
|---|---|---|
| Category | Citation of document with indication, where appropriate, of relevant passages | Relevant to claim |
| | GB - A - 508 046 (SIEMENS APPARATE UND MASCHINEN GmbH) <br> * Page 1, line 71 to page 2, line 53; figures 1-4 * <br><br> -- | 1,2 |
| | US - A - 4 182 987 (C.R. MOELLER) <br> * column 3, lines 6-40; figure 5 * <br><br> -- | 1,2 |
| | REPORTS ON PROGRESS IN PHYSICS, vol. 35, no. 8, 1972, London, GB <br> STUART: "Earth's field magnetometry", pages 804-881. <br> * Page 839, paragraph 2 to page 841, paragraph 1; page 843, last paragraph to page 944, paragraph 1; figures 19,23 * <br><br> -- | 1-3 |
| | DE - B - 1 909 435 (BURROUGHS CORP.) <br> * Column 1, line 32 to column 2, line 29; figures 1-4 * <br><br> ---- | 1,2 |

**CLASSIFICATION OF THE APPLICATION (Int Cl.³)**

G 01 R 33/02

**TECHNICAL FIELDS SEARCHED (Int Cl.³)**

G 01 R 33/00
33/02
33/04

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family.
corresponding document

The present search report has been drawn up for all claims

| Place of search | Date of completion of the search | Examiner |
|---|---|---|
| The Hague | 23-11-1981 | STUBNER |

EPO Form 1503.1 06.78